# EUROPEAN PATENT APPLICATION

(11) **EP 4 693 475 A1**
(43) Date of publication of application: **11.02.2026**
(21) Application number: 24892711.3
(22) Date of filing: 15.05.2024
(51) Int. Cl.: H01M 4/36, H01M 4/133, B82Y 30/00

(54) **SILICON-CARBON COMPOSITE MATERIAL AND PREPARATION METHOD THEREFOR, SECONDARY BATTERY, AND ELECTRIC DEVICE**

(30) Priority: 20.11.2023 CN 202311549841
(71) Applicant: Contemporary Amperex Technology Co., Limited, Ningde, Fujian 352100 (CN)
(72) Inventor: WU, Kai, Ningde, Fujian 352100 (CN); YUN, Liang, Ningde, Fujian 352100 (CN); SUN, Xin, Ningde, Fujian 352100 (CN); YE, Yonghuang, Ningde, Fujian 352100 (CN)
(74) Representative: Ziebig Hengelhaupt Intellectual Property Attorneys Patentanwaltskanzlei PartGmbB
(86) International application number: PCT/CN2024/093427
(87) International publication number: WO 2025/107546

(57) **Abstract**

Provided are a silicon-carbon composite material and a preparation method therefor, a secondary battery, and an electric device. The silicon-carbon composite material comprises silicon-carbon secondary particles; the silicon-carbon secondary particles comprise silicon-carbon primary particles and one-dimensional conductive agents; the one-dimensional conductive agents are distributed between the silicon-carbon primary particles. The silicon-carbon composite material has excellent electron transport performance, is beneficial to reducing the fast charging time for a battery, increases the number of cycles of the battery, can improve the rate capability and cycle performance of the battery, and comprehensively improves the electrochemical performance of the battery.

## Description

### CROSS-REFERENCE

The present application claims priority to Chinese Patent Application No. 202311549841.3 filed on November 20, 2023 and entitled "SILICON-CARBON COMPOSITE MATERIAL AND PREPARATION METHOD THEREFOR, SECONDARY BATTERY, AND ELECTRIC DEVICE", which is incorporated herein by reference in its entirety.

### TECHNICAL FIELD

The present application relates to the technical field of secondary batteries, and in particular, to a silicon-carbon composite material and a preparation method therefor, a secondary battery, and an electric device.

### BACKGROUND

In recent years, secondary batteries have been widely used in energy storage power systems such as hydropower, thermal power, wind power, and solar power stations, as well as in various fields such as electric tools, electric bicycles, electric motorcycles, electric vehicles, military equipment, and aerospace.

Negative electrode active materials are important components of secondary batteries. To further improve the energy density of batteries, silicon-based negative electrode active materials have been extensively studied. However, due to their large volume expansion, silicon-based materials may affect the electrochemical performance of the batteries during use.

### SUMMARY

The present application is made in view of the issues described above, and an objective of the present application is to provide a silicon-carbon composite material with an excellent electron transport performance, which is beneficial to shortening the fast charge time of a battery, and increasing the number of cycles of the battery, such that the rate performance and cycle performance of the battery can be improved, and the electrochemical performance of the battery can be comprehensively improved.

To achieve the objective described above, a first aspect of the present application provides a silicon-carbon composite material. The silicon-carbon composite material includes silicon-carbon secondary particles, where the silicon-carbon secondary particles include silicon-carbon primary particles and a one-dimensional conductive agent, and the one-dimensional conductive agent is distributed between the silicon-carbon primary particles.

In one aspect, the one-dimensional conductive agent is distributed between the silicon-carbon primary particles, and the one-dimensional conductive agent serves as a "bridge" between the silicon-carbon primary particles to interconnect the primary particles. This greatly increases contact sites between the primary particles and effectively reduces electrical inactivation caused by poor contact between the primary particles and expansion and contraction of the primary particles during charging and discharging, such that the silicon-carbon composite material exhibits excellent electron transport performance, thereby improving the migration kinetics of active ions, shortening the fast charge time of the battery, and improving the rate performance of the material. In another aspect, the one-dimensional conductive agent serves as a conductive buffer matrix, and meanwhile, the one-dimensional conductive agent can be linearly wound on the silicon-carbon primary particles to effectively bind the silicon-carbon primary particles, such that the volume change of the primary particles during deintercalation of active ions can be effectively suppressed by utilizing the elasticity and binding effect of the matrix, thereby improving the cycling stability and lithium storage capacity of the silicon-carbon composite material and prolonging the cycle life of the battery.

In any embodiment, a diameter of the one-dimensional conductive agent is less than or equal to 10 nm, optionally 0.5 nm to 5 nm; and/or a length of the one-dimensional conductive agent is 1 µm to 5 µm, optionally 3 µm to 5 µm; and/or an aspect ratio of the one-dimensional conductive agent is 1000 to 5000, optionally 3000 to 5000.

By regulating the diameter or length or the aspect ratio of the one-dimensional conductive agent within an appropriate range, it is beneficial to improving electron conduction between the primary particles, such that the silicon-carbon composite material exhibits excellent electron transport performance, thereby improving the migration kinetics of the active ions, shortening the fast charge time of the battery, and improving the rate performance of the material.

In any embodiment, a mass content of the one-dimensional conductive agent is less than or equal to 0.7%, optionally 0.3% to 0.6%, based on a mass of the silicon-carbon secondary particles.

Maintaining the mass content of the one-dimensional conductive agent within an appropriate range enables the primary particles to have excellent electrical contact with each other, thereby achieving the purpose of improving the rate performance and cycle performance of the secondary battery, and also reducing the influence on the cycle performance of the battery caused by the internal structure change of the material due to excessive mass content of the one-dimensional conductive agent. The one-dimensional conductive agent with the appropriate mass content range can balance the rate performance and cycle performance of the battery, thereby comprehensively improving the performance of the battery.

In any embodiment, a particle size of the silicon-carbon primary particles is 20 nm to 100 nm, optionally 20 nm to 60 nm.

Maintaining the particle size of the silicon-carbon primary particle within an appropriate range enables the one-dimensional conductive agent to interconnect a sufficient number of silicon-carbon primary particles, and enables the primary particles to have excellent electrical contact with each other, thereby achieving the purpose of improving the rate performance of the secondary battery. Meanwhile, maintaining the particle size of the silicon-carbon primary particles within the appropriate range enables the silicon-carbon secondary particles to have an appropriate particle size, such that the structure of the silicon-carbon composite material is relatively stable, and the battery has an excellent cycle performance.

In any embodiment, the silicon-carbon primary particles include:
a porous carbon skeleton; and
a silicon-based material, where at least a portion of the silicon-based material is arranged in pores of the porous carbon skeleton.

The silicon-carbon primary particles have a stable porous skeleton structure which has a relatively strong supporting capability characterized by high stress capability and excellent mechanical properties and electrical conductivity. The pore structure in the porous carbon skeleton thereof provides ample space for arranging the silicon-based material, thereby enabling high-capacity silicon storage. When the porous carbon skeleton is compounded with the silicon-based material, the silicon-based material is not prone to agglomeration and can be uniformly dispersed in the pores of the porous carbon skeleton. After the porous carbon skeleton is compounded with silicon particles, the electrical conductivity of the silicon-carbon primary particles can be improved, and meanwhile, the volume effect of silicon during deintercalation of lithium can be alleviated. Moreover, the stress change of the silicon-based material can be fully withstood, thereby ensuring the structural stability of the silicon-carbon composite material, improving the cycling stability and lithium storage capacity of the silicon-carbon composite material, and prolonging the cycle life of the battery.

In any embodiment, the porous carbon skeleton satisfies at least one of the following (1) to (2):
(1) a pore volume of the porous carbon skeleton is 0.7 cm³/g to 1.0 cm³/g; and
(2) a pore size of the porous carbon skeleton is 0.7 nm to 3 nm, optionally 0.8 nm to 1.5 nm.

Maintaining the pore volume of the porous carbon skeleton within an appropriate range can not only ensure the stability of the skeleton structure, but also meet the capacity for silicon deposition. The silicon particles adhere to the inside of the pores, and the silicon particles and the porous carbon skeleton can act synergistically, thereby improving the capacity and electrical conductivity of the silicon-carbon composite material and improving the rate performance and energy density of the battery.

Maintaining the pore size of the porous carbon skeleton within an appropriate range facilitates the subsequent entry of the silicon particles into the pores of the porous carbon skeleton, thereby reducing the risk of silicon deposition on the surface of the porous carbon skeleton. In addition, it is beneficial for the particles to approach full deposition in the porous carbon skeleton, thereby improving the electronic conductivity and ionic conductivity of the material and improving the rate performance of the material.

In any embodiment, the silicon-carbon primary particles satisfy at least one of the following (3) to (4):
(1) a specific surface area of the silicon-carbon primary particles is 1 m²/g to 20 m²/g, optionally 8 m²/g to 15 m²/g; and
(2) a mass fraction of the silicon-based material is 30% to 50%, optionally 35% to 45%, based on a mass of the silicon-carbon primary particles.

Controlling the specific surface area of the silicon-carbon primary particles within an appropriate range enables the one-dimensional conductive agent to bind the silicon-carbon primary particles in a linear structure, thereby achieving the purpose of suppressing the volume change of the primary particles during deintercalation of active ions, which facilitates improving the cycle performance of the battery.

Controlling the mass fraction of the silicon-based material within an appropriate range enables the silicon-carbon composite material to have a high specific capacity, thereby improving the energy density of the battery. Meanwhile, the volume expansion of the silicon-carbon composite material is limited to a specific range, such that the silicon-carbon composite material has certain structural stability.

In any embodiment, the silicon-carbon secondary particles satisfy at least one of the following (5) to (8):
(5) a specific surface area of the silicon-carbon secondary particles is 0.1 m²/g to 0.8 m²/g, optionally 0.15 m²/g to 0.6 m²/g;
(6) a volume distribution particle size Dv50 of the silicon-carbon secondary particles is 0.9 µm to 3 µm;
(7) a tap density of the silicon-carbon secondary particles is 0.75 g/cm³ to 1.00 g/cm³; and
(8) a powder resistivity of the silicon-carbon secondary particles at 5 MPa is 0.1 Ω·cm to 10.0 Ω·cm, optionally 0.1 Ω·cm to 1.0 Ω·cm.

Controlling the specific surface area of the silicon-carbon secondary particles within an appropriate range enables the material to have an excellent kinetic performance, thereby being favorable for the rate performance of the secondary battery.

Controlling the volume distribution particle size Dv50 of the silicon-carbon secondary particles within an appropriate range enables the silicon-carbon composite material to have a relatively stable structure and exhibit good kinetic performance, thereby improving the rate performance and cycle performance of the secondary battery.

Controlling the tap density of the silicon-carbon secondary particles within an appropriate range can improve the compaction density of the negative electrode plate and the energy density of the secondary battery; it is also beneficial for the negative electrode plate to have appropriate pore distribution, thereby improving the ion and electron transport performance, and improving the infiltration characteristic of the negative electrode plate into the electrolytic solution, which further improves the rate performance and cycle performance of the secondary battery.

Controlling the powder resistivity of the silicon-carbon secondary particles at 5 MPa within an appropriate range can improve the electronic conductivity of the negative electrode plate, thereby further improving the rate performance of the battery.

In any embodiment, the one-dimensional conductive agent includes carbon nanotubes and carbon fibers, optionally carbon nanotubes, and more optionally single-armed carbon nanotubes.

In any embodiment, a carbon layer is provided on at least a part of a surface of the silicon-carbon composite material.

The carbon layer coating the silicon-carbon composite material is beneficial for improving the electrical conductivity of the silicon-carbon composite material, thereby improving the rate performance of the material. Meanwhile, the carbon layer can improve the stability between the silicon-carbon composite material and the electrolytic solution, thereby improving the cycle performance of the battery.

A second aspect of the present application provides a preparation method for a silicon-carbon composite material. The preparation method includes:
mixing and granulating silicon-carbon primary particles and a one-dimensional conductive agent in a solvent, and performing spray drying to obtain the silicon-carbon composite material,
where the silicon-carbon composite material includes silicon-carbon secondary particles, the silicon-carbon secondary particles include the silicon-carbon primary particles and the one-dimensional conductive agent, and the one-dimensional conductive agent is distributed between the silicon-carbon primary particles.

In the preparation method described above, mixing the one-dimensional conductive agent and the silicon-carbon primary particles in a liquid phase enables the one-dimensional conductive agent to be distributed between the silicon-carbon primary particles. The one-dimensional conductive agent serves as a "bridge" between the silicon-carbon primary particles to interconnect the primary particles. This greatly increases contact sites between the primary particles and effectively reduces electrical inactivation caused by poor contact between the primary particles and expansion and contraction of the primary particles during charging and discharging, such that the silicon-carbon composite material exhibits excellent electron transport performance, thereby improving the migration kinetics of active ions, shortening the fast charge time of the battery, and improving the rate performance of the material. In another aspect, the one-dimensional conductive agent serves as a conductive buffer matrix, and the one-dimensional conductive agent can be further linearly wound on the silicon-carbon primary particles to effectively bind the silicon-carbon primary particles, such that the volume change of the primary particles during deintercalation of active ions can be effectively suppressed by utilizing the elasticity and binding effect of the matrix, thereby improving the cycling stability and lithium storage capacity of the silicon-carbon composite material and prolonging the cycle life of the battery.

In any embodiment, the preparation method specifically includes:
polymerization reaction: performing a polymerization reaction on aniline, inositol hexaphosphate, and an initiator to obtain a mixed precursor;
high-temperature carbonization: performing high-temperature carbonization treatment on the mixed precursor to obtain a carbonized pretreated material;
activation and pore formation: introducing water vapor into the carbonized pretreated material for activation and pore formation treatment to obtain porous carbon skeleton primary particles;
silicon deposition: depositing silicon in the porous carbon skeleton primary particles to obtain silicon-carbon primary particles; and
mixing and granulation: mixing and granulating the silicon-carbon primary particles and a one-dimensional conductive agent in a solvent, and performing spray drying to obtain the silicon-carbon composite material.

According to the preparation method described above, firstly, aniline and inositol hexaphosphate are polymerized under the action of the initiator to generate carbon material precursor polyaniline microspheres; then, the high-temperature carbonization step is adopted to fully carbonize polyaniline to obtain the primary particles of a carbon material with high electrical conductivity; the activation and pore formation step is adopted to facilitate generating the primary particles having a porous carbon skeleton so as to obtain the porous carbon skeleton with a high pore size or pore volume, which is favorable for subsequent silicon deposition. Silicon particles are deposited in pores of the porous carbon skeleton primary particles to obtain the silicon-carbon primary particles. Finally, the silicon-carbon primary particles and the one-dimensional conductive agent are mixed in the liquid phase, and the silicon-carbon composite material is obtained after spray drying.

In any embodiment, a reaction temperature of the polymerization reaction is 60 °C to 280 °C, optionally 80 °C to 250 °C; and/or a reaction time of the polymerization reaction is 1 h to 15 h, optionally 5 h to 12 h.

Controlling the reaction time and the reaction temperature of the polymerization reaction enables the particle size of the polyaniline microspheres to be controlled, thereby achieving the purpose of controlling the particle size of the primary particles of the carbon material.

In any embodiment, a deposition temperature for silicon deposition is 400 °C to 900 °C, optionally 500 °C to 650 °C; and/or a deposition time for silicon deposition is 6 h to 24 h, optionally 8 h to 18 h.

Controlling the deposition time and the deposition temperature for silicon deposition within appropriate ranges enables silicon to be uniformly dispersed in the pores of the porous carbon skeleton, resulting in the silicon-carbon composite material with excellent structural parameters.

In any embodiment, the preparation method further includes preparing a carbon layer: performing carbon coating treatment on a surface of the silicon-carbon composite material.

Coating the surface of the silicon-carbon composite material with the carbon layer is beneficial to improving the electrical conductivity of the silicon-carbon composite material, such that the rate performance of the material is improved. Meanwhile, the carbon layer can improve the stability between the silicon-carbon composite material and the electrolytic solution, thereby improving the cycle performance of the battery.

A third aspect of the present application provides a secondary battery. The secondary battery includes a negative electrode plate. The negative electrode plate includes the silicon-carbon composite material according to the first aspect of the present application or the silicon-carbon composite material prepared by the preparation method according to the second aspect of the present application.

A fourth aspect of the present application provides an electric device. The electric device includes the secondary battery according to the third aspect of the present application.

### BRIEF DESCRIPTION OF THE DRAWINGS

FIG. 1 is a schematic view of a secondary battery according to an embodiment of the present application;
FIG. 2 is an exploded view of the secondary battery according to an embodiment of the present application as shown in FIG. 1;
FIG. 3 is a schematic view of a battery module according to an embodiment of the present application;
FIG. 4 is a schematic view of a battery pack according to an embodiment of the present application;
FIG. 5 is an exploded view of the battery pack according to an embodiment of the present application as shown in FIG. 4;
FIG. 6 is a schematic view of an electric device using a secondary battery as a power source according to an embodiment of the present application; and
FIG. 7 is a schematic structural view of a silicon-carbon composite material according to the present application.

### Description of the reference numerals:

1: battery pack; 2: upper case body; 3: lower case body; 4: battery module; 5: secondary battery; 51: housing body; 52: electrode assembly; 53: top cover assembly.

### DETAILED DESCRIPTION

Hereinafter, embodiments specifically disclosing a silicon-carbon composite material and a preparation method therefor, a secondary battery, and an electric device of the present application are described in detail with appropriate reference to the drawings. However, unnecessarily detailed descriptions may be omitted. For example, detailed descriptions of well-known matters and repetitive descriptions of actually identical structures may be omitted. This is to avoid unnecessary lengthiness of the following descriptions and to facilitate understanding by those skilled in the art. Additionally, the drawings and the following descriptions are provided to enable those skilled in the art to fully understand the present application and are not intended to limit the subject matter recited in the claims.

The "ranges" disclosed in the present application are defined with lower and upper limits. A given range is defined by selecting a lower limit and an upper limit that delineate the boundaries of a particular range. Ranges defined in this manner may include or exclude the end values and can be combined arbitrarily, which means that any lower limit may be combined with any upper limit to form a range. For example, if ranges of 60-120 and 80-110 are listed for a particular parameter, it is understood that ranges of 60-110 and 80-120 are also anticipated. Additionally, if the minimum range values listed are 1 and 2, and the maximum range values listed are 3, 4, and 5, then the following ranges can all be anticipated: 1-3, 1-4, 1-5, 2-3, 2-4, and 2-5. In the present application, unless otherwise specified, the numerical range "a-b" indicates an abbreviated representation of any combination of real numbers between a and b, where both a and b are real numbers. For example, the numerical range "0-5" indicates that all real numbers between "0-5" are listed herein, and "0-5" is merely an abbreviated representation of a combination of these numerical values. Additionally, when stating that a parameter is an integer ≥ 2, it is equivalent to disclosing that the parameter is, for example, an integer of 2, 3, 4, 5, 6, 7, 8, 9, 10, 11, 12, or the like.

Unless otherwise specified, all embodiments and optional embodiments of the present application can be combined with one another to form new technical solutions.

Unless otherwise specified, all technical features and optional technical features of the present application can be combined with one another to form new technical solutions.

Unless otherwise specified, all steps of the present application can be performed sequentially or randomly, preferably sequentially. For example, if the method includes steps (a) and (b), it indicates that the method may include steps (a) and (b) performed sequentially or steps (b) and (a) performed sequentially. For example, if the mentioned method may further include step (c), it indicates that step (c) may be added to the method in any order; for example, the method may include steps (a), (b) and (c), or steps (a), (c) and (b), or steps (c), (a) and (b), or the like.

Unless otherwise specified, the "include" and "comprise" mentioned in the present application are open-ended or closed-ended. For example, the "include" and "comprise" may mean that other unlisted components may also be included or comprised or that only the listed components are included or comprised.

Unless otherwise specified, the term "or" in the present application is inclusive. For example, the phrase "A or B" means "A, B, or both A and B". More specifically, any one of the following conditions satisfies the condition "A or B": A is true (or present) and B is false (or absent); A is false (or absent) and B is true (or present); or both A and B are true (or present).

The silicon-carbon composite material is one of the commonly used active materials. At present, the preparation of the silicon-carbon composite material mainly involves directly mixing silicon with carbon materials. The silicon-carbon materials have to have a certain limitation on the silicon content. When the silicon content is too high, the silicon-carbon composite material expands greatly, which will cause the silicon-carbon composite material to be broken and pulverized, the materials lose electrical contact with each other to cause rapid degradation of the capacity, and the cycling stability of the battery becomes poor. In addition, the electrical conductivity of the silicon-carbon composite material itself is poor, which severely limits its further application. Therefore, a new silicon-carbon composite material needs to be designed to meet the requirements of the new generation of electrochemistry.

### [Silicon-Carbon Composite Material]

Based on this, the present application provides a silicon-carbon composite material. The silicon-carbon composite material includes silicon-carbon secondary particles. The silicon-carbon secondary particles include silicon-carbon primary particles and a one-dimensional conductive agent, and the one-dimensional conductive agent is distributed between the silicon-carbon primary particles.

Both the silicon-carbon primary particles and the silicon-carbon secondary particles have meanings well known in the art. The silicon-carbon primary particles refer to particles in a non-agglomerated state. The silicon-carbon secondary particles refer to particles in an agglomerated state formed by aggregation of two or more silicon-carbon primary particles. The silicon-carbon primary particles and the silicon-carbon secondary particles can be distinguished by using scanning electron microscope (SEM) images.

Herein, the term "one-dimensional conductive agent" refers to a conductive agent having a one-dimensional microstructure, including, but not limited to, carbon nanotubes and carbon fibers.

In one aspect, the one-dimensional conductive agent is distributed between the silicon-carbon primary particles; that is, the one-dimensional conductive agent serves as a "bridge" between the silicon-carbon primary particles to interconnect the primary particles. This greatly increases contact sites between the primary particles and effectively reduces electrical inactivation caused by poor contact between the primary particles and expansion and contraction of the primary particles during charging and discharging, such that the silicon-carbon composite material exhibits excellent electron transport performance, thereby improving the migration kinetics of active ions, shortening the fast charge time of the battery, and improving the rate performance of the material. In another aspect, the one-dimensional conductive agent serves as a conductive buffer matrix, and meanwhile, the one-dimensional conductive agent can be further linearly wound on the silicon-carbon primary particles to effectively bind the silicon-carbon primary particles, such that the volume change of the primary particles during deintercalation of active ions can be effectively suppressed by utilizing the elasticity and binding effect of the matrix, thereby improving the cycling stability and lithium storage capacity of the silicon-carbon composite material and prolonging the cycle life of the battery.

In some embodiments, the diameter of the one-dimensional conductive agent is less than or equal to 10 nm. In some embodiments, the diameter of the one-dimensional conductive agent is optionally any one of 0.5 nm, 1 nm, 1.5 nm, 2 nm, 2.5 nm, 3 nm, 3.5 nm, 4 nm, 4.5 nm, 5 nm, 5.5 nm, 6 nm, 6.5 nm, 7 nm, 7.5 nm, 8 nm, 8.5 nm, 9 nm, 9.5 nm, and 10 nm, or in a range defined by any two of these values.

The diameter or length of the one-dimensional conductive agent can be tested using methods and devices known in the art. For example, the test can be performed by using an SEM (e.g., ZEISS Sigma 300). As an example, the test can be performed according to the following steps: Firstly, a negative electrode plate including the silicon-carbon composite material is cut into a sample to be tested with a certain size (e.g., 6 mm × 6 mm), and the sample to be tested is sandwiched between two electrically and thermally conductive sheets (such as copper foils). The sample to be tested and the sheets are stuck and fixed with an adhesive (such as a double-sided adhesive) and pressed with a flat iron block with a certain mass (such as about 400 g) for a certain period of time (such as 1 h), to minimize gaps between the sample to be tested and the copper foils. After that, the edges are trimmed neatly with scissors, and the sample to be tested is stuck to a sample stage with a conductive adhesive, with the sample slightly extending beyond the edge of the sample stage. Then, the sample stage is placed into a sample holder and locked in place, and an argon ion cross-section polisher (e.g., IB-19500CP) is turned on and evacuated (e.g., 10 Pa to 4 Pa). After setting the argon flow (e.g., 0.15 MPa), voltage (e.g., 8 KV), and polishing time (e.g., 2 h), the sample stage is adjusted to an oscillation mode to begin polishing. After the polishing is completed, an ion-polished cross-sectional morphology (CP) image of the silicon-carbon composite material is obtained by using an SEM (e.g., ZEISS Sigma 300). Subsequently, the diameter or length of the one-dimensional conductive agent is counted, a normal distribution curve is plotted, and the diameter or length on the normal distribution curve is taken as the diameter and length of the one-dimensional conductive agent.

Controlling the diameter of the one-dimensional conductive agent within an appropriate range enables a sufficient amount of the one-dimensional conductive agent to be distributed between the primary particles; that is, a sufficient number of "bridges" are established between the primary particles to achieve the purpose of improving the electrical conductivity of the silicon-carbon composite material. Meanwhile, maintaining the diameter of the one-dimensional conductive agent within an appropriate range can also improve the infiltration capacity of an electrolytic solution in the silicon-carbon composite material, thereby being beneficial to improving the rate performance of the battery.

In some embodiments, the diameter of the one-dimensional conductive agent is 0.5 nm to 5 nm. In some embodiments, the diameter of the one-dimensional conductive agent is optionally any one of 0.5 nm, 1 nm, 1.5 nm, 2 nm, 2.5 nm, 3 nm, 3.5 nm, 4 nm, 4.5 nm, and 5 nm, or in a range defined by any two of these values.

Controlling the diameter of the one-dimensional conductive agent within an appropriate range can further shorten the fast charge time of the battery, and extend the number of cycles of the battery, thereby improving the rate performance and cycle performance of the battery.

In some embodiments, the length of the one-dimensional conductive agent is 1 µm to 5 µm. In some embodiments, the length of the one-dimensional conductive agent is optionally any one of 1 µm, 2 µm, 3 µm, 4 µm, and 5 µm, or in a range defined by any two of these values.

Controlling the length of the one-dimensional conductive agent within an appropriate range enables, in one aspect, the "bridge" between the primary particles to be long enough to achieve the purpose of connecting the primary particles, and the primary particles can further be linearly wound to achieve the purpose of restraining the expansion of the primary particles. In another aspect, the one-dimensional conductive agent with an appropriate length also reduces the possibility of breakage of the one-dimensional conductive agent during the cycling of the battery.

In some embodiments, the length of the one-dimensional conductive agent is 3 µm to 5 µm. In some embodiments, the length of the one-dimensional conductive agent is optionally any one of 3 µm, 3.5 µm, 4 µm, 4.5 µm, and 5 µm, or in a range defined by any two of these values.

Maintaining the length of the one-dimensional conductive agent within an appropriate range can further increase the number of cycles of the battery, and shorten the fast charge time of the battery, thereby improving the cycle performance and rate performance of the battery.

In some embodiments, the aspect ratio of the one-dimensional conductive agent is 1000 to 5000. In some embodiments, the aspect ratio of the one-dimensional conductive agent is optionally any one of 1000, 2000, 3000, 4000, and 50000, or in a range defined by any two of these values.

By regulating the aspect ratio of the one-dimensional conductive agent within an appropriate range, it is beneficial to improving electron conduction between the primary particles, such that the silicon-carbon composite material exhibits excellent electron transport performance, thereby improving the migration kinetics of the active ions, shortening the fast charge time of the battery, and improving the rate performance of the material.

In some embodiments, the aspect ratio of the one-dimensional conductive agent is 3000 to 5000. In some embodiments, the aspect ratio of the one-dimensional conductive agent is optionally any one of 3000, 3500, 4000, 4500, and 50000, or in a range defined by any two of these values.

Controlling the aspect ratio of the one-dimensional conductive agent within an appropriate range can further increase the number of cycles of the battery, and shorten the fast charge time of the battery, thereby improving the cycle performance and rate performance of the battery.

In some embodiments, the mass content of the one-dimensional conductive agent is less than or equal to 0.7%, based on the mass of the silicon-carbon secondary particles.

In some embodiments, the mass content of the one-dimensional conductive agent is optionally any one of 0.02%, 0.05%, 0.1%, 0.2%, 0.3%, 0.4%, 0.5%, and 0.6%, or in a range defined by any two of these values, based on the mass of the silicon-carbon secondary particles.

In some embodiments, the mass content of the one-dimensional conductive agent is optionally any one of 0.3%, 0.4%, 0.5%, and 0.6%, or in a range defined by any two of these values, based on the mass of the silicon-carbon secondary particles.

Maintaining the mass content of the one-dimensional conductive agent within an appropriate range enables the primary particles to have excellent electrical contact with each other, thereby achieving the purpose of improving the rate performance and cycle performance of the secondary battery, and also reducing the influence on the cycle performance of the battery caused by the internal structure change of the material due to excessive mass content of the one-dimensional conductive agent. The one-dimensional conductive agent with the appropriate mass content range can balance the rate performance and cycle performance of the battery, thereby comprehensively improving the performance of the battery.

In some embodiments, the particle size of the silicon-carbon primary particles is 20 nm to 100 nm. In some embodiments, the particle size of the silicon-carbon primary particles is optionally any one of 20 nm, 30 nm, 40 nm, 50 nm, 60 nm, 70 nm, 80 nm, 90 nm, and 100 nm, or in a range defined by any two of these values.

The particle size of the silicon-carbon primary particles can be tested using methods and devices known in the art. For example, the test can be performed by using an SEM (e.g., ZEISS Sigma 300). As an example, the test can be performed according to the following steps: Firstly, a negative electrode plate including the silicon-carbon composite material is cut into a sample to be tested with a certain size (e.g., 6 mm × 6 mm), and the sample to be tested is sandwiched between two electrically and thermally conductive sheets (such as copper foils). The sample to be tested and the sheets are stuck and fixed with an adhesive (such as a double-sided adhesive) and pressed with a flat iron block with a certain mass (such as about 400 g) for a certain period of time (such as 1 h), to minimize gaps between the sample to be tested and the copper foils. After that, the edges are trimmed neatly with scissors, and the sample to be tested is stuck to a sample stage with a conductive adhesive, with the sample slightly extending beyond the edge of the sample stage. Then, the sample stage is placed into a sample holder and locked in place, and an argon ion cross-section polisher (e.g., IB-19500CP) is turned on and evacuated (e.g., 10 Pa to 4 Pa). After setting the argon flow (e.g., 0.15 MPa), voltage (e.g., 8 KV), and polishing time (e.g., 2 h), the sample stage is adjusted to an oscillation mode to begin polishing. After the polishing is completed, an ion-polished cross-sectional morphology (CP) image of the silicon-carbon composite material is obtained by using an SEM (e.g., ZEISS Sigma 300). According to the ion-polished cross-sectional morphology (CP) image of the silicon-carbon composite material obtained above, the particle size of the silicon-carbon primary particles is counted by using the equivalent circle area. The particle size of the silicon-carbon primary particles in the present application is the area-equivalent circle diameter, and the area of each silicon-carbon primary particle can be obtained through statistics using graphic software.

Maintaining the particle size of the silicon-carbon primary particle within an appropriate range enables the one-dimensional conductive agent to interconnect a sufficient number of silicon-carbon primary particles, and enables the primary particles to have excellent electrical contact with each other, thereby achieving the purpose of improving the rate performance of the secondary battery. Meanwhile, maintaining the particle size of the silicon-carbon primary particles within the appropriate range enables the silicon-carbon secondary particles to have an appropriate particle size, such that the structure of the silicon-carbon composite material is relatively stable, and the battery has an excellent cycle performance.

In some embodiments, the particle size of the silicon-carbon primary particles is 20 nm to 60 nm. In some embodiments, the particle size of the silicon-carbon primary particles is optionally any one of 20 nm, 30 nm, 40 nm, 50 nm, and 60 nm, or in a range defined by any two of these values.

Controlling the particle size of the silicon-carbon primary particles within an appropriate range enables the one-dimensional conductive agent to interconnect a sufficient number of primary particles, which can further prolong the discharge time of the battery and shorten the charge time of the battery, thereby further improving the rate performance of the battery.

In some embodiments, the silicon-carbon primary particles include: a porous carbon skeleton; and a silicon-based material. At least a portion of the silicon-based material is arranged in pores of the porous carbon skeleton.

The silicon-carbon primary particles have a stable porous skeleton structure which has a relatively strong supporting capability characterized by high stress capability and excellent mechanical properties and electrical conductivity. The pore structure in the porous carbon skeleton thereof provides ample space for arranging the silicon-based material, thereby enabling high-capacity silicon storage. When the porous carbon skeleton is compounded with the silicon-based material, the silicon-based material is not prone to agglomeration and can be uniformly dispersed in the pores of the porous carbon skeleton. After the porous carbon skeleton is compounded with silicon particles, the electrical conductivity of the silicon-carbon primary particles can be improved, and meanwhile, the volume effect of silicon during deintercalation of lithium can be alleviated. Moreover, the stress change of the silicon-based material can be fully withstood, thereby ensuring the structural stability of the silicon-carbon composite material, improving the cycling stability and lithium storage capacity of the silicon-carbon composite material, and prolonging the cycle life of the battery.

In some embodiments, the pore volume of the porous carbon skeleton is 0.7 cm³/g to 1.0 cm³/g.

In some embodiments, the pore volume of the porous carbon skeleton is optionally 0.7 cm³/g, 0.75 cm³/g, 0.8 cm³/g, 0.85 cm³/g, 0.90 cm³/g, 0.95 cm³/g, 1.0 cm³/g, or a value in a range defined by any two of the points described above.

The pore volume of the porous carbon skeleton has a meaning well known in the art, and can be measured using instruments and methods well known in the art. For example, the test method may refer to the GB/T 19587-2004. The Barret Joyner Halenda (BJH) method for testing mesoporous pore size distribution is used. Under a micro-mesoporous model, the gas adsorption-desorption method is used for testing, and data of the adsorption branch are selected to obtain the pore volume of the material.

Maintaining the pore volume of the porous carbon skeleton within an appropriate range can not only ensure the stability of the skeleton structure, but also meet the capacity for silicon deposition. The silicon particles adhere to the inside of the pores, and the silicon particles and the porous carbon skeleton can act synergistically, thereby improving the capacity and electrical conductivity of the silicon-carbon composite material and improving the rate performance and energy density of the battery.

In some embodiments, the pore size of the porous carbon skeleton is 0.7 nm to 3 nm. In some embodiments, the pore size of the porous carbon skeleton is optionally 0.7 nm, 1 nm, 1.5 nm, 2 nm, 2.5 nm, 3 nm, or a value in a range defined by any two of the points described above.

In some embodiments, the pore size of the porous carbon skeleton is 0.8 nm to 1.5 nm. In some embodiments, the pore size of the porous carbon skeleton is optionally 0.8 nm, 0.9 nm, 1.0 nm, 1.1 nm, 1.2 nm, 1.3 nm, 1.4 nm, 1.5 nm, or a value in a range defined by any two of the points described above.

The pore size of the porous carbon skeleton has a meaning well known in the art and can be measured using instruments and methods well known in the art. As an example, a certain amount of the porous carbon skeleton prepared above is taken as a sample, and the porous carbon skeleton sample is analyzed by using an SEM to obtain an SEM image. Then, pore sizes are counted, a normal distribution curve is plotted, and a median pore size on the normal distribution curve is taken as the pore size of the porous carbon skeleton.

Maintaining the pore size of the porous carbon skeleton within an appropriate range facilitates the subsequent entry of the silicon particles into the pores of the porous carbon skeleton, thereby reducing the risk of silicon deposition on the surface of the porous carbon skeleton. In addition, it is beneficial for the particles to approach full deposition in the porous carbon skeleton, thereby improving the electronic conductivity and ionic conductivity of the material and improving the rate performance of the material.

In some embodiments, the specific surface area of the silicon-carbon primary particles is 1 m²/g to 20 m²/g. In some embodiments, the specific surface area of the silicon-carbon primary particles is optionally any one of 1 m²/g, 5 m²/g, 10 m²/g, 15 m²/g, and 20 m²/g, or in a range defined by any two of these values.

In some embodiments, the specific surface area of the silicon-carbon primary particles is 8 m²/g to 15 m²/g. In some embodiments, the specific surface area of the silicon-carbon primary particles is optionally any one of 8 m²/g, 9 m²/g, 10 m²/g, 11 m²/g, 12 m²/g, 13 m²/g, 14 m²/g, and 15 m²/g, or in a range defined by any two of these values.

The specific surface area of the silicon-carbon primary particles has a meaning well known in the art and can be tested using methods known in the art. As an example, the specific surface area of the porous carbon skeleton is tested using a 3 Flex specific surface area analyzer from the Micromeritics Instrument Corporation, USA. The specific surface area BET of the silicon-carbon primary particles is obtained by fitting using the T-Plot method.

Controlling the specific surface area of the silicon-carbon primary particles within an appropriate range enables the one-dimensional conductive agent to bind the silicon-carbon primary particles in a linear structure, thereby achieving the purpose of suppressing the volume change of the primary particles during deintercalation of active ions, which facilitates improving the cycle performance of the battery.

In some embodiments, the mass fraction of the silicon-based material is 30% to 50%, based on the mass of the silicon-carbon primary particles. In some embodiments, the mass fraction of the silicon-based material is optionally any one of 30%, 35%, 40%, 45%, and 50%, or in a range defined by any two of these values, based on the mass of the silicon-carbon primary particles.

In some embodiments, the mass fraction of the silicon-based material is 35% to 45%, based on the mass of the silicon-carbon primary particles. In some embodiments, the mass fraction of the silicon-based material is optionally any one of 35%, 40%, and 45%, or in a range defined by any two of these values, based on the mass of the silicon-carbon primary particles.

The mass content of the silicon-based material can be tested by methods and devices known in the art. For example, the test can be performed with reference to the EPA 6010D-2014 standard. Specifically, inductively coupled plasma optical emission spectrometry (ICP-OES) can be used for elemental analysis. Firstly, a sample to be tested is dissolved into a liquid with a strong acid, then the liquid is introduced into an ICP light source in an atomization mode, and further, after gaseous atoms to be tested are ionized and excited in a strong magnetic field, they return from an excited state to a ground state. During the process described above, the energy is released and recorded as different characteristic spectral lines for the quantitative analysis of elements.

Controlling the mass fraction of the silicon-based material within an appropriate range enables the silicon-carbon composite material to have a high specific capacity, thereby improving the energy density of the battery. Meanwhile, the volume expansion of the silicon-carbon composite material is limited to a specific range, such that the silicon-carbon composite material has certain structural stability.

In some embodiments, the specific surface area of the silicon-carbon secondary particles is 0.1 m²/g to 0.8 m²/g. In some embodiments, the specific surface area of the silicon-carbon secondary particles is optionally any one of 0.1 m²/g, 0.2 m²/g, 0.3 m²/g, 0.4 m²/g, 0.5 m²/g, 0.6 m²/g, 0.7 m²/g, and 0.8 m²/g, or in a range defined by any two of these values.

In some embodiments, the specific surface area of the silicon-carbon secondary particles is 0.15 m²/g to 0.6 m²/g. In some embodiments, the specific surface area of the silicon-carbon secondary particles is optionally any one of 0.15 m²/g, 0.2 m²/g, 0.3 m²/g, 0.4 m²/g, 0.5 m²/g, and 0.6 m²/g, or in a range defined by any two of these values.

The specific surface area of the silicon-carbon secondary particles has a meaning well known in the art and can be tested using methods known in the art. As an example, the specific surface area of the silicon-carbon secondary particles is tested using a 3 Flex specific surface area analyzer from the Micromeritics Instrument Corporation, USA. The specific surface area BET of the silicon-carbon secondary particles is obtained by fitting using the T-Plot method.

Controlling the specific surface area of the silicon-carbon secondary particles within an appropriate range enables the material to have an excellent kinetic performance, thereby being favorable for the rate performance of the secondary battery.

In some embodiments, the volume distribution particle size Dv50 of the silicon-carbon secondary particles is 0.9 µm to 3 µm. In some embodiments, the volume distribution particle size Dv50 of the silicon-carbon secondary particles is optionally any one of 0.9 µm, 1 µm, 1.5 µm, 2 µm, 2.5 µm, and 3 µm, or in a range defined by any two of these values.

The volume distribution particle size Dv50 of the silicon-carbon secondary particles has a meaning well known in the art and can be tested using methods known in the art. For example, the silicon-carbon secondary particle sample is measured according to the GB/T 19077-2016/ISO 13320:2009 standard, and a laser particle size analyzer (e.g., Malvern Master Size 3000) can be used as the testing device.

Controlling the volume distribution particle size Dv50 of the silicon-carbon secondary particles within an appropriate range enables the silicon-carbon composite material to have a relatively stable structure and exhibit good kinetic performance, thereby improving the rate performance and cycle performance of the secondary battery.

In some embodiments, the tap density of the silicon-carbon secondary particles is 0.75 g/cm³ to 1.00 g/cm³. In some embodiments, the tap density of the silicon-carbon secondary particles is optionally any one of 0.75 g/cm³, 0.80 g/cm³, 0.85 g/cm³, 0.90 g/cm³, 0.95 g/cm³, and 1.00 g/cm³, or in a range defined by any two of these values.

The tap density of the silicon-carbon secondary particles has a meaning well known in the art and can be measured using instruments and methods known in the art. For example, the measurement can be performed with reference to the GB/T 5162-2006 using a powder tap density tester. The tester may be a Bettersize BT-301, with the following test parameters: vibration frequency of 250 ± 15 times/minute, amplitude of 3 ± 0.2 mm, total vibrations of 5000 times, and graduated cylinder volume of 25 mL.

Controlling the tap density of the silicon-carbon secondary particles within an appropriate range can improve the compaction density of the negative electrode plate and the energy density of the secondary battery; it is also beneficial for the negative electrode plate to have appropriate pore distribution, thereby improving the ion and electron transport performance, and improving the infiltration characteristic of the negative electrode plate into the electrolytic solution, which further improves the rate performance and cycle performance of the secondary battery.

In some embodiments, the powder resistivity of the silicon-carbon secondary particles at 5 MPa is 0.1 Ω·cm to 10 Ω·cm. In some embodiments, the powder resistivity of the silicon-carbon secondary particles at 5 MPa is optionally any one of 0.1 Ω·cm, 1 Ω·cm, 2 Ω·cm, 3 Ω·cm, 4 Ω·cm, 5 Ω·cm, 6 Ω·cm, 7 Ω·cm, 8 Ω·cm, 9 Ω·cm, and 10 Ω·cm, or in a range defined by any two of these values.

In some embodiments, the powder resistivity of the silicon-carbon secondary particles at 5 MPa is 0.1 Ω·cm to 1 Ω·cm. In some embodiments, the powder resistivity of the silicon-carbon secondary particles at 5 MPa is optionally any one of 0.1 Ω·cm, 0.2 Ω·cm, 0.3 Ω·cm, 0.4 Ω·cm, 0.5 Ω·cm, 0.6 Ω·cm, 0.7 Ω·cm, 0.8 Ω·cm, 0.6 Ω·cm, and 1.0 Ω·cm, or in a range defined by any two of these values.

The powder resistivity of the silicon-carbon secondary particles has a meaning well known in the art and can be tested using instruments and methods known in the art. For example, the test may be performed using a resistivity tester (e.g., ST2722 powder resistivity tester from Suzhou Jingge Electronics Co., Ltd.). Specifically, 1 g of powder sample is placed between electrodes of the resistivity tester and compressed under constant pressure via an electronic press to the test pressure (e.g., 5 MPa). The pressure is maintained for 15 s to 25 s to obtain a sheet-like sample. The powder resistivity δ (unit: Ω·cm) of the material is calculated according to the formula: δ = (S × R)/h, where h represents the height (unit: cm) of the sheet-like sample, R represents the resistance (unit: Ω), and S represents the area (unit: cm²) of the sheet-like sample.

In some embodiments, the one-dimensional conductive agent includes carbon nanotubes and carbon fibers.

In some embodiments, the one-dimensional conductive agent includes carbon nanotubes.

Compared with the carbon fibers, the carbon nanotubes are of a hollow structure, which adds ion transport channels, thereby facilitating the circulation of the electrolytic solution in the tube. This is beneficial to improving the electrical conductivity of the material, and improving the rate performance of the battery.

In some embodiments, the one-dimensional conductive agent includes multi-walled carbon nanotubes or single-walled carbon nanotubes.

In some embodiments, the one-dimensional conductive agent includes single-walled carbon nanotubes.

The performance of the single-walled carbon nanotubes is superior to that of the multi-walled carbon nanotubes. Using the single-walled carbon nanotubes as the one-dimensional conductive agent can further improve the cycle performance and rate performance of the battery.

In some embodiments, a carbon layer is provided on at least a part of a surface of the silicon-carbon composite material.

The carbon layer coating the silicon-carbon composite material is beneficial for improving the electrical conductivity of the silicon-carbon composite material, thereby improving the rate performance of the material. Meanwhile, the carbon layer can improve the stability between the silicon-carbon composite material and the electrolytic solution, thereby improving the cycle performance of the battery.

In some embodiments of the present application, provided is a preparation method for a silicon-carbon composite material. The preparation method includes:
mixing and granulating silicon-carbon primary particles and a one-dimensional conductive agent in a solvent, and performing spray drying to obtain the silicon-carbon composite material. The silicon-carbon composite material includes silicon-carbon secondary particles, the silicon-carbon secondary particles include the silicon-carbon primary particles and the one-dimensional conductive agent, and the one-dimensional conductive agent is distributed between the silicon-carbon primary particles.

In the preparation method described above, mixing the one-dimensional conductive agent and the silicon-carbon primary particles in a liquid phase enables the one-dimensional conductive agent to be distributed between the silicon-carbon primary particles; that is, the one-dimensional conductive agent serves as a "bridge" between the silicon-carbon primary particles to interconnect the primary particles. This greatly increases contact sites between the primary particles and effectively reduces electrical inactivation caused by poor contact between the primary particles and expansion and contraction of the primary particles during charging and discharging, such that the silicon-carbon composite material exhibit excellent electron transport performance, thereby improving the migration kinetics of active ions, shortening the fast charge time of the battery, and improving the rate performance of the material. In another aspect, the one-dimensional conductive agent serves as a conductive buffer matrix, and meanwhile, the one-dimensional conductive agent can be linearly wound on the silicon-carbon primary particles to effectively bind the silicon-carbon primary particles, such that the volume change of the primary particles during deintercalation of active ions can be effectively suppressed by utilizing the elasticity and binding effect of the matrix, thereby improving the cycling stability and lithium storage capacity of the silicon-carbon composite material and prolonging the cycle life of the battery.

In some embodiments, the preparation method specifically includes:
polymerization reaction: performing a polymerization reaction on aniline, inositol hexaphosphate, and an initiator to obtain a mixed precursor;
high-temperature carbonization: performing high-temperature carbonization treatment on the mixed precursor to obtain a carbonized pretreated material;
activation and pore formation: introducing water vapor into the carbonized pretreated material for activation and pore formation treatment to obtain porous carbon skeleton primary particles;
silicon deposition: depositing silicon in the porous carbon skeleton primary particles to obtain silicon-carbon primary particles; and
mixing and granulation: mixing and granulating the silicon-carbon primary particles and the one-dimensional conductive agent in a solvent, and performing spray drying to obtain the silicon-carbon composite material.

According to the preparation method described above, firstly, aniline and inositol hexaphosphate are polymerized under the action of the initiator to generate carbon material precursor polyaniline microspheres; then, the high-temperature carbonization step is adopted to fully carbonize polyaniline to obtain the primary particles of a carbon material with high electrical conductivity; the activation and pore formation step is adopted to facilitate generating the primary particles having a porous carbon skeleton so as to obtain the porous carbon skeleton with a high pore size or pore volume, which is favorable for subsequent silicon deposition. Silicon particles are deposited in pores of the porous carbon skeleton primary particles to obtain the silicon-carbon primary particles. Finally, the silicon-carbon primary particles and the one-dimensional conductive agent are mixed in the liquid phase, and the silicon-carbon composite material is obtained after spray drying.

In some embodiments, the initiator includes persulfate. In some embodiments, the initiator is optionally ammonium persulfate or potassium persulfate.

In some embodiments, the solvent in the mixing and granulation step is any one or a combination of at least two of an alcohol solvent, a ketone solvent, an ether solvent, and water.

In some embodiments, the reaction temperature of the polymerization reaction is 60 °C to 280 °C. In some embodiments, the reaction temperature of the polymerization reaction is optionally any one of 60 °C, 80 °C, 100 °C, 120 °C, 140 °C, 160 °C, 200 °C, 220 °C, 240 °C, 260 °C, and 280 °C, or in a range defined by any two of these values. In some embodiments, the reaction temperature of the polymerization reaction is 80 °C to 250 °C. In some embodiments, the reaction temperature of the polymerization reaction is optionally any one of 80 °C, 90 °C, 100 °C, 110 °C, 120 °C, 140 °C, 160 °C, 180 °C, 220 °C, and 250 °C, or in a range defined by any two of these values.

In some embodiments, the reaction time of the polymerization reaction is 1 h to 15 h. In some embodiments, the reaction time of the polymerization reaction is optionally any one of 1 h, 2 h, 3 h, 4 h, 5 h, 6 h, 7 h, 8 h, 9 h, 10 h, 11 h, 12 h, 13 h, 14 h, and 15 h, or in a range defined by any two of these values.

In some embodiments, the reaction time of the polymerization reaction is 5 h to 12 h. In some embodiments, the reaction time of the polymerization reaction is optionally any one of 5 h, 6 h, 7 h, 8 h, 9 h, 10 h, 11 h, and 12 h, or in a range defined by any two of these values.

Controlling the reaction time or the reaction temperature of the polymerization reaction enables the particle size of the polyaniline microspheres to be controlled, thereby achieving the purpose of controlling the particle size of the primary particles of the carbon material.

In some embodiments, the temperature of the high-temperature carbonization is 600 °C to 900 °C.

In some embodiments, the time for the high-temperature carbonization is 4 h to 12 h.

In some embodiments, the treatment temperature for the activation and pore formation is 400 °C to 500 °C.

In some embodiments, the treatment time for the activation and pore formation is 4 h to 8 h.

In some embodiments, the flow rate of the water vapor is 0.5 g/min to 1 g/min.

Controlling the treatment temperature and the treatment time for the activation and pore formation and the flow rate of the water vapor within appropriate ranges enables the pore size and the pore volume of the porous carbon skeleton to be within appropriate ranges, thereby obtaining the porous carbon skeleton with excellent structural properties.

In some embodiments, the deposition temperature for silicon deposition is 400°C to 900°C. In some embodiments, the deposition temperature for vapor deposition of silicon is optionally any one of 400 °C, 500 °C, 600 °C, 700 °C, 800 °C, and 900 °C, or in a range defined by any two of these values.

In some embodiments, the deposition temperature for silicon deposition is 500 °C to 650 °C. In some embodiments, the deposition temperature for vapor deposition of silicon is optionally any one of 500 °C, 550 °C, 600 °C, and 650 °C, or in a range defined by any two of these values. In some embodiments, the deposition time for silicon deposition is 6 h to 24 h. In some embodiments, the deposition time for silicon deposition is optionally any one of 6 h, 10 h, 15 h, 20 h, and 24 h, or in a range defined by any two of these values. In some embodiments, the deposition time for silicon deposition is 8 h to 18 h. In some embodiments, the deposition time for silicon deposition is optionally any one of 8 h, 10 h, 12 h, 14 h, and 16 h, or in a range defined by any two of these values. Controlling the deposition time or the deposition temperature for vapor deposition of silicon within an appropriate range enables silicon to be uniformly dispersed in the pores of the porous carbon skeleton, resulting in the silicon-carbon composite material with excellent structural parameters.

In some embodiments, the preparation method further includes preparing a carbon layer: performing carbon coating treatment on the surface of the silicon-carbon composite material.

In some embodiments, the carbon coating treatment includes any one of carbon coating by a chemical vapor deposition method, carbon coating by a pyrolysis method, carbon coating by a hydrothermal method, or carbon coating by polyelectrolyte modification.

Coating the surface of the silicon-carbon composite material with the carbon layer is beneficial to improving the electrical conductivity of the silicon-carbon composite material, such that the rate performance of the material is improved. Meanwhile, the carbon layer can improve the stability between the silicon-carbon composite material and the electrolytic solution, thereby improving the cycle performance of the battery.

In one embodiment of the present application, provided is a secondary battery.

Typically, the secondary battery includes a positive electrode plate, a negative electrode plate, an electrolyte, and a separator. During the charging and discharging process of the battery, active ions are intercalated and deintercalated back and forth between the positive electrode plate and the negative electrode plate. The electrolyte conducts ions between the positive electrode plate and the negative electrode plate. The separator is arranged between the positive electrode plate and the negative electrode plate to primarily prevent the positive and negative electrodes from short-circuiting while allowing the passage of ions.

### [Positive Electrode Plate]

The positive electrode plate includes a positive electrode current collector and a positive electrode film layer arranged on at least one surface of the positive electrode current collector, and the positive electrode film layer includes a positive electrode active material.

As an example, the positive electrode current collector has two surfaces opposite to each other in its own thickness direction, and the positive electrode film layer is arranged on any one or both of the two opposite surfaces of the positive electrode current collector.

In some embodiments, a metal foil or a composite current collector may be used as the positive electrode current collector. For example, an aluminum foil may be used as the metal foil. The composite current collector may include a polymer material base layer and a metal layer formed on at least one surface of the polymer material base layer. The composite current collector may be formed by forming a metal material (aluminum, aluminum alloy, nickel, nickel alloy, titanium, titanium alloy, silver, silver alloy, or the like) on a polymer material substrate (such as polypropylene (PP), polyethylene terephthalate (PET), polybutylene terephthalate (PBT), polystyrene (PS), and polyethylene (PE)).

In some embodiments, a positive electrode active material for use in batteries known in the art may be used as the positive electrode active material. As an example, the positive electrode active material may include at least one of the following materials: a lithium-containing phosphate with an olivine structure, a lithium transition metal oxide, and respective modified compounds thereof. However, the present application is not limited to these materials, and other conventional materials that can be used as positive electrode active materials for batteries may also be used. These positive electrode active materials may be used alone or in combination of two or more. Examples of the lithium transition metal oxide may include, but are not limited to, at least one of a lithium cobalt oxide (such as LiCoO₂), a lithium nickel oxide (such as LiNiO₂), a lithium manganese oxide (such as LiMnO₂ or LiMn₂O₄), a lithium nickel cobalt oxide, a lithium manganese cobalt oxide, a lithium nickel manganese oxide, a lithium nickel cobalt manganese oxide (such as LiNi_{1/3}Co_{1/3}Mn_{1/3}O₂ (also referred to as NCM333), LiNi_{0.5}Co_{0.2}Mn_{0.3}O₂ (also referred to as NCM523), LiNi_{0.5}Co_{0.25}Mn_{0.25}O₂ (also referred to as NCM211), LiNi_{0.6}Co_{0.2}Mn_{0.2}O₂ (also referred to as NCM622), LiNi_{0.8}Co_{0.1}Mn_{0.1}O₂ (also referred to as NCM811)), a lithium nickel cobalt aluminum oxide (such as LiNi_{0.85}Co_{0.15}Al_{0.05}O₂), and modified compounds thereof. Examples of the lithium-containing phosphate with an olivine structure may include, but are not limited to, at least one of lithium iron phosphate (such as LiFePO₄ (also referred to as LFP)), a composite material of lithium iron phosphate and carbon, lithium manganese phosphate (such as LiMnPO₄), a composite material of lithium manganese phosphate and carbon, lithium manganese iron phosphate, and a composite material of lithium manganese iron phosphate and carbon.

In some embodiments, the positive electrode film layer further optionally includes a binder. As an example, the binder may include at least one of polyvinylidene fluoride (PVDF), polytetrafluoroethylene (PTFE), vinylidene fluoride-tetrafluoroethylene-propylene terpolymer, vinylidene fluoride-hexafluoropropylene-tetrafluoroethylene terpolymer, tetrafluoroethylene-hexafluoropropylene copolymer, and fluorinated acrylic resin.

In some embodiments, the positive electrode film layer further optionally includes a conductive agent. As an example, the conductive agent may include at least one of superconducting carbon, acetylene black, carbon black, Ketjen black, a carbon dot, a carbon nanotube, graphene, and a carbon nanofiber.

In some embodiments, the positive electrode plate can be prepared in the following manner: dispersing the components described above for preparing the positive electrode plate, such as the positive electrode active material, the conductive agent, the binder, and any other components, in a solvent (such as N-methylpyrrolidone) to form a positive electrode slurry; and coating the positive electrode current collector with the positive electrode slurry, and performing drying, cold pressing, and other processes to obtain the positive electrode plate.

### [Negative Electrode Plate]

The negative electrode plate includes a negative electrode current collector and a negative electrode film layer arranged on at least one surface of the negative electrode current collector. The negative electrode film layer includes a negative electrode active material. The negative electrode active material includes the silicon-carbon composite material in some embodiments or the silicon-carbon composite material prepared by the preparation method in some embodiments.

As an example, the negative electrode current collector has two surfaces opposite to each other in its own thickness direction, and the negative electrode film layer is arranged on any one or both of the two opposite surfaces of the negative electrode current collector.

In some embodiments, a metal foil or a composite current collector may be used as the negative electrode current collector. For example, a copper foil may be used as the metal foil. The composite current collector may include a polymer material base layer and a metal layer formed on at least one surface of the polymer material substrate. The composite current collector may be formed by forming a metal material (copper, copper alloy, nickel, nickel alloy, titanium, titanium alloy, silver, silver alloy, etc.) on a polymer material substrate (such as polypropylene (PP), polyethylene terephthalate (PET), polybutylene terephthalate (PBT), polystyrene (PS), and polyethylene (PE)).

In some embodiments, a negative electrode active material for use in batteries known in the art may be used as the negative electrode active material. As an example, the negative electrode active material may include at least one of the following materials: artificial graphite, natural graphite, soft carbon, hard carbon, a silicon-based material, a tin-based material, lithium titanate, and the like. The silicon-based material may be selected from at least one of elemental silicon, a silicon-oxygen compound, a silicon-carbon composite, a silicon-nitrogen composite, and a silicon alloy. The tin-based material may be selected from at least one of elemental tin, a tin-oxygen compound, and a tin alloy. However, the present application is not limited to these materials, and other conventional materials that can be used as negative electrode active materials for batteries may also be used. These negative electrode active materials may be used alone or in combination of two or more.

In some embodiments, the mass content of the silicon-carbon composite material is greater than or equal to 20%, based on the total mass of the negative electrode active material.

In some embodiments, based on the total mass of the negative electrode active material, the mass content of the silicon-carbon composite material is optionally any one of greater than or equal to 20%, greater than or equal to 25%, greater than or equal to 30%, greater than or equal to 35%, greater than or equal to 40%, greater than or equal to 45%, greater than or equal to 50%, greater than or equal to 55%, greater than or equal to 60%, greater than or equal to 65%, greater than or equal to 70%, greater than or equal to 75%, greater than or equal to 80%, greater than or equal to 85%, greater than or equal to 90%, and greater than or equal to 95%.

Controlling the silicon-carbon composite material within an appropriate range enables the battery to have an excellent energy density and cycle performance.

In some embodiments, the mass content of the silicon-carbon composite material is 25% to 90%, based on the total mass of the negative electrode active material.

In some embodiments, the mass content of the silicon-carbon composite material is optionally any one of 25%, 30%, 40%, 50%, 60%, 70%, 80%, and 90%, or in a range defined by any two of these values, based on the total mass of the negative electrode active material.

Controlling the silicon-carbon composite material within an appropriate range can balance both the energy density and the cycle life of the battery, thereby comprehensively improving the electrochemical performance of the battery.

In some embodiments, the negative electrode film layer further optionally includes a binder. The binder may be selected from at least one of styrene-butadiene rubber (SBR), polyacrylic acid (PAA), sodium polyacrylate (PAAS), polyacrylamide (PAM), polyvinyl alcohol (PVA), sodium alginate (SA), polymethacrylic acid (PMAA), and carboxymethyl chitosan (CMCS).

In some embodiments, the negative electrode film layer further optionally includes a conductive agent. The conductive agent may be selected from at least one of superconducting carbon, acetylene black, carbon black, Ketjen black, a carbon dot, a carbon nanotube, graphene, and a carbon nanofiber.

In some embodiments, the negative electrode film layer further optionally includes other auxiliary agents, such as a thickener (e.g., sodium carboxymethylcellulose (CMC-Na)).

In some embodiments, the negative electrode plate can be prepared in the following manner: dispersing the components described above for preparing the negative electrode plate, such as the negative electrode active material, the conductive agent, the binder, and any other components, in a solvent (such as deionized water) to form a negative electrode slurry; and coating the negative electrode current collector with the negative electrode slurry, and performing drying, cold pressing, and other processes to obtain the negative electrode plate.

### [Electrolyte]

The electrolyte conducts ions between the positive electrode plate and the negative electrode plate. The present application has no specific restrictions on the type of the electrolyte, which can be selected according to needs. For example, the electrolyte may be liquid, gel, or all solid.

In some embodiments, the electrolyte is an electrolytic solution. The electrolytic solution includes an electrolyte salt and a solvent.

In some embodiments, the electrolyte salt may be selected from at least one of lithium hexafluorophosphate, lithium tetrafluoroborate, lithium perchlorate, lithium hexafluoroarsenate, lithium bis(fluorosulfonyl)imide, lithium bis(trifluoromethanesulfonyl)imide, lithium trifluoromethanesulfonate, lithium difluorophosphate, lithium difluoro(oxalato)borate, lithium bis(oxalato)borate, lithium difluorobis(oxalato)phosphate, and lithium tetrafluoro(oxalato)phosphate.

In some embodiments, the solvent may be selected from at least one of ethylene carbonate, propylene carbonate, ethyl methyl carbonate, diethyl carbonate, dimethyl carbonate, dipropyl carbonate, methyl propyl carbonate, ethyl propyl carbonate, butylene carbonate, fluoroethylene carbonate, methyl formate, methyl acetate, ethyl acetate, propyl acetate, methyl propionate, ethyl propionate, propyl propionate, methyl butyrate, ethyl butyrate, 1,4-butyrolactone, sulfolane, dimethyl sulfone, ethyl methyl sulfone, and diethyl sulfone.

In some embodiments, the electrolytic solution further optionally includes an additive. For example, the additive may include a negative electrode film-forming additive and a positive electrode film-forming additive, and may further include an additive capable of improving certain properties of the battery, such as an additive for improving the overcharge performance of the battery and an additive for improving the high-temperature or low-temperature performance of the battery.

### [Separator]

In some embodiments, the secondary battery further includes a separator. The present application does not particularly limit the type of the separator, and any porous-structure separator well known to have good chemical stability and mechanical stability may be selected and used.

In some embodiments, the separator may be made of a material selected from at least one of glass fiber, non-woven fabric, polyethylene, polypropylene, and polyvinylidene difluoride. The separator may be a single-layer film or a multi-layer composite film, and there is no particular limitation on this. When the separator is a multi-layer composite film, the materials of the layers may be the same or different, and there is no particular limitation on this.

In some embodiments, the positive electrode plate, the negative electrode plate, and the separator may be manufactured into an electrode assembly through a winding process or a stacking process.

In some embodiments, the secondary battery includes a positive electrode plate, an electrolytic solution, a separator, and a negative electrode plate in some embodiments.

In some embodiments, the secondary battery includes a lithium-ion battery.

In some embodiments, the secondary battery may include an outer packaging. The outer packaging can be used for packaging the electrode assembly and electrolyte described above.

In some embodiments, the outer packaging of the secondary battery may be a hard shell, such as a hard plastic shell, an aluminum shell, or a steel shell. The outer packaging of the secondary battery may also be a soft pack, such as a pouch-type soft pack. The soft pack may be made of plastic, and examples of the plastic may include polypropylene, polybutylene terephthalate, polybutylene succinate, and the like.

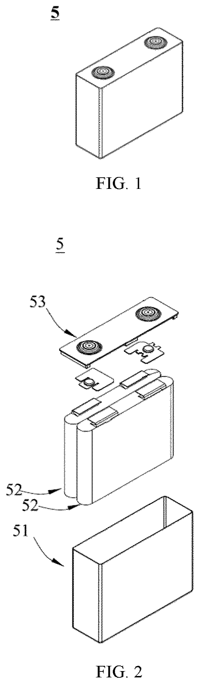

The present application does not particularly limit the shape of the secondary battery, and it may have a cylindrical shape, a prismatic shape, or any other shape. For example, FIG. 1 shows a secondary battery 5 having a prismatic structure as one example.

In some embodiments, referring to FIG. 2, the outer packaging may include a housing body 51 and a cover plate 53. The housing body 51 may include a bottom plate and side plates connected to the bottom plate, and the bottom plate and the side plates define, in an enclosing manner, an accommodating cavity. The housing body 51 is provided with an opening in communication with the accommodating cavity, and the cover plate 53 is capable of lidding the opening to close the accommodating cavity. The positive electrode plate, the negative electrode plate, and the separator may be subjected to a winding process or a stacking process to form an electrode assembly 52. The electrode assembly 52 is packaged in the accommodating cavity. The electrolytic solution is infiltrated into the electrode assembly 52. The number of the electrode assemblies 52 included in the secondary battery 5 may be one or more, and those skilled in the art can select the number according to specific and actual needs.

In some embodiments, the secondary battery may be assembled into a battery module. The number of secondary batteries included in the battery module may be one or more, and the specific number may be selected by those skilled in the art based on the use and capacity of the battery module.

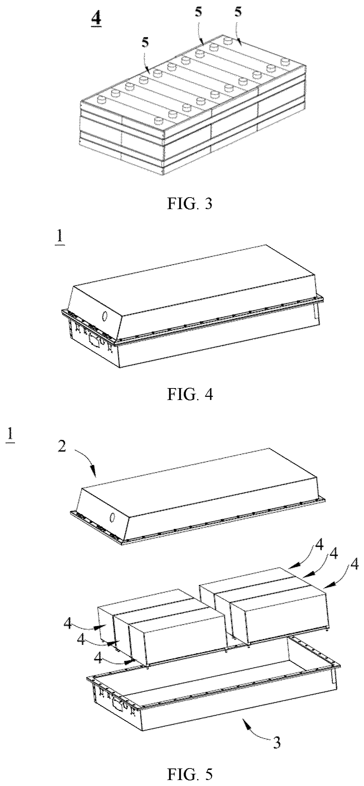

FIG. 3 shows a battery module 4 as an example. Referring to FIG. 3, in the battery module 4, a plurality of secondary batteries 5 may be sequentially arranged in the length direction of the battery module 4. Certainly, the arrangement may also be in any other manner. Further, the plurality of secondary batteries 5 may be fixed by a fastener.

Optionally, the battery module 4 may further include a housing having an accommodating space in which the plurality of secondary batteries 5 are accommodated.

In some embodiments, the battery module described above may also be assembled into a battery pack. The number of battery modules included in the battery pack may be one or more, and the specific number may be selected by those skilled in the art based on the use and capacity of the battery pack.

FIG. 4 and FIG. 5 show a battery pack 1 as an example. Referring to FIG. 4 and FIG. 5, the battery pack 1 may include a battery case and a plurality of battery modules 4 arranged in the battery case. The battery case includes an upper case body 2 and a lower case body 3. The upper case body 2 is capable of lidding the lower case body 3 to form a closed space for accommodating the battery modules 4. The plurality of battery modules 4 may be arranged in any manner in the battery case.

In addition, the present application further provides an electric device. The electric device includes at least one of the secondary battery, the battery module, or the battery pack provided in the present application. The secondary battery, the battery module, or the battery pack may be used as a power source for the electric device, and they may also be used as an energy storage unit for the electric device. The electric device may include, but is not limited to, a mobile device (e.g., a mobile phone or a laptop computer), an electric vehicle (e.g., a pure electric vehicle, a hybrid electric vehicle, a plug-in hybrid electric vehicle, an electric bicycle, an electric scooter, an electric golf cart, or an electric truck), an electric train, a ship, or a satellite, an energy storage system, or the like.

As the electric device, a secondary battery, a battery module, or a battery pack may be selected based on its use requirements.

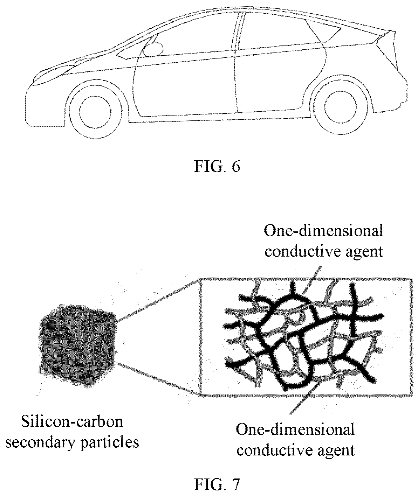

FIG. 6 shows an electric device as an example. The electric device is a pure electric vehicle, a hybrid electric vehicle, a plug-in hybrid electric vehicle, or the like. To meet the requirements of the electric device for high power and high energy density of the secondary battery, a battery pack or a battery module may be used.

As another example, the device may be a mobile phone, a tablet computer, a laptop computer, or the like. The device is generally required to be light and thin, and a secondary battery may thus be used as a power source.

### Examples

Hereinafter, examples of the present application are described. The examples described below are illustrative and merely used to explain the present application, and they should not be construed as limiting the present application. The examples without techniques or conditions specified therein are implemented according to techniques or conditions described in the literature in the art or according to product instructions. Reagents or instruments used herein without specified manufacturers are all commercially available conventional products.

### I. Preparation Method

### Example 1

### 1) Preparation of Silicon-Carbon Composite Material

500 g of aniline was dissolved in 2000 mL of inositol hexaphosphate and uniformly dispersed, and then 50 g of ammonium persulfate was added. A reaction solution was obtained after uniform stirring, and the reaction solution was placed in a reaction kettle and reacted at 180 °C for 8 h. A powder was obtained after drying, and then the powder was placed in a muffle furnace and subjected to carbonization at a temperature of 900 °C for 4 h under nitrogen protection. Water vapor was introduced into the carbonized product at 450 °C for activation and pore formation treatment for 6 h, where the flow rate of the water vapor was 1 g/min, and then porous carbon skeleton primary particles were obtained.

With silane used as a silicon source and nitrogen used as a protective gas, vapor deposition was performed in a tube furnace to obtain a silicon-carbon composite material, where the flow rate of the silane was 0.06 L/min, and the flow rate of the protective gas was 4 L/min. The vapor deposition was performed at a temperature of 450 °C for 6 h to obtain silicon-carbon primary particles. 19.9 g of single-walled carbon nanotube dispersion liquid (a solid content of 0.03%, a length of single-walled carbon nanotubes of 3 µm, and a diameter of 5 nm), and the prepared silicon-carbon primary particles were added into a certain amount of tetrahydrofuran, and mixed, such that a mixed slurry with a solid content of 10% was obtained. The mixed slurry was subjected to spray drying, with an air outlet temperature of 95 °C and a feed rate of 0.6 L/h, to obtain a silicon-carbon material of secondary particles, and a one-dimensional conductive agent was distributed between the silicon-carbon primary particles.

With methane used as a carbon source and nitrogen used as a protective gas, vapor deposition of the carbon source was performed on the substance obtained by spray drying in a tube furnace, where the flow rate of the methane was 6 L/min, and the flow rate of the protective gas was 15 L/min. The vapor deposition was performed at a temperature of 900 °C for 6 h, and a gas source was shut off for cooling to obtain the silicon-carbon composite material.

### 2) Preparation of Positive Electrode Plate

A nickel-cobalt-manganese LiNi_{0.95}Co_{0.04}Mn_{0.01}O₂ (NCM) ternary material, a conductive agent carbon black, and a binder polyvinylidene difluoride (PVDF) were mixed in a mass ratio of 97%:1%:2%. N-methylpyrrolidone was added, and a positive electrode slurry was obtained after uniform mixing. Then a positive electrode current collector was coated with the positive electrode slurry, followed by drying, cold pressing, and slitting to obtain a positive electrode plate.

### 3) Preparation of Negative Electrode Plate

Graphite and the silicon-carbon composite material prepared in Example 1 were mixed in a mass ratio of 3:7 to obtain a negative electrode active material, where the mass fraction of the silicon-carbon composite material is 70%, based on the total mass of the negative electrode active material.

The negative electrode active material, a conductive agent carbon black, carbon nanotubes (CNT), a binder styrene-butadiene rubber (SBR), and a thickener sodium hydroxymethylcellulose (CMC) were added into deionized water according to a weight ratio of 94.5%:1%:0.375%:2.8%:1.325%, and uniformly mixed to obtain a negative electrode slurry. A negative electrode current collector was coated with the slurry, followed by drying, cold pressing, and slitting to obtain a negative electrode plate.

### 4) Separator

A polypropylene film was used as a separator.

### 5) Preparation of Electrolytic solution

In an argon atmosphere glove box (H₂O < 0.1 ppm, O₂ < 0.1 ppm), organic solvents ethylene carbonate, ethyl methyl carbonate, diethyl carbonate, and fluoroethylene carbonate (FEC) were uniformly mixed in a volume ratio of 1:1:1:1. LiPF₆ was then added and dissolved in the organic solvent, followed by uniform stirring to obtain the electrolytic solution of Example 1, with the concentration of the electrolytic solution of 1 mol/L.

### 6) Preparation of Battery

The positive electrode plate, the separator, and the negative electrode plate of Example 1 were stacked in sequence, with the separator placed between the positive electrode plate and the negative electrode plate to play a role in separation, and then wound to obtain a battery cell. Tabs were welded to the battery cell, and the battery cell was placed into an aluminum case. Then, an electrolytic solution was injected, and the aluminum case was sealed. After procedures such as standing, cold pressing, formation, shaping, and capacity testing, a lithium-ion secondary battery was obtained.

### Examples 2-3

The preparation parameters in Examples 2-3 are substantially the same as those in Example 1, except that the single-walled carbon nanotubes were replaced with multi-walled carbon nanotubes and vapor-grown carbon fibers, where the length of the multi-walled carbon nanotubes is 2 µm and the diameter thereof is 80 nm, and the length of the vapor-grown carbon fibers is 4 µm and the diameter thereof is 2 nm. The specific parameters are shown in Table 1.

### Examples 4-11

The preparation parameters in Examples 4-11 are substantially the same as those in Example 1, except that the diameter and length of the added single-walled carbon nanotubes were adjusted, and then the length and diameter of the single-walled carbon nanotubes in the silicon-carbon composite material were adjusted. In Example 4, the length of the single-walled carbon nanotubes is 3 µm, and the diameter thereof is 0.5 nm. In Example 5, the length of the single-walled carbon nanotubes is 3 µm, and the diameter thereof is 1 nm. In Example 6, the length of the single-walled carbon nanotubes is 3 µm, and the diameter thereof is 10 nm. In Example 7, the length of the single-walled carbon nanotubes is 3 µm, and the diameter thereof is 12 nm. In Example 8, the length of the single-walled carbon nanotubes is 0.5 µm, and the diameter thereof is 1 nm. In Example 8, the length of the single-walled carbon nanotubes is 0.5 µm, and the diameter thereof is 1 nm. In Example 9, the length of the single-walled carbon nanotubes is 1 µm, and the diameter thereof is 1 nm. In Example 10, the length of the single-walled carbon nanotubes is 5 µm, and the diameter thereof is 1 nm. In Example 11, the length of the single-walled carbon nanotubes is 7 µm, and the diameter thereof is 1 nm. The specific parameters are shown in Table 1.

### Examples 12-14

The preparation parameters in Examples 12-14 are substantially the same as those in Example 1, except that the solid content of the added single-walled carbon nanotube dispersion liquid was adjusted, where the solid content in Example 12 is 0.00995%, the solid content in Example 13 is 0.09286%, and the solid content in Example 14 is 0.1194%. The specific parameters are shown in Table 1.

### Examples 15-18

The preparation parameters in Examples 15-18 are substantially the same as those in Example 1, except that the reaction temperature and the reaction time of the polymerization reaction were adjusted, and then the volume distribution particle size Dv50 of the silicon-carbon primary particles was adjusted. In Example 15, the temperature of the polymerization reaction is 220 °C, and the reaction time thereof is 4 h; in Example 16, the temperature of the polymerization reaction is 230 °C, and the reaction time thereof is 6 h; in Example 17, the temperature of the polymerization reaction is 122 °C, and the reaction time thereof is 11 h; in Example 18, the temperature of the polymerization reaction is 138 °C, and the reaction time thereof is 13 h. The specific parameters are shown in Table 1.

### Comparative Example 1

The preparation parameters in Comparative Examples 1-2 are substantially the same as those in Example 1, except that the preparation parameters of the silicon-carbon composite material were adjusted. The specific parameters are shown in Table 1, and the specific preparation method is as follows:
Comparative Example 1: This example is different from Example 1 in that the single-walled carbon nanotubes were replaced with conductive carbon black.
Comparative Example 2: This example is different from Example 1 in that no single-walled carbon nanotubes were added.
Comparative Example 3:

1000 g of lignin and 200 g of KOH were uniformly mixed and then subjected to sintering treatment under a nitrogen protective atmosphere at a heating rate of 1 °C/min and a heat treatment temperature of 1150 °C. The mixture was kept at this temperature for 5 h, then cooled, washed with water to remove impurities, and dried to obtain a three-dimensional porous carbon skeleton. 1000 g of the obtained three-dimensional porous carbon skeleton was placed into a CVD furnace and heated to 1000 °C at a rate of 5 °C/min. High-purity nitrogen was introduced at a rate of 4.0 L/min, methane gas was introduced at a rate of 0.5 L/min, silane gas was introduced at a rate of 0.5 L/min, and the mixed gas was introduced for a period of 8 h. After natural cooling to room temperature, a precursor 2 was obtained. 1000 g of the obtained silicon-carbon precursor 2 was placed in a CVD furnace, and heated to 1000 °C at a rate of 5 °C/min. High-purity nitrogen was introduced at a rate of 4.0 L/min. Methane gas was introduced at a rate of 0.5 L/min for a period of 4 h. After natural cooling to room temperature, a silicon-carbon composite material was obtained.

### Comparative Example 4:

500 g of aniline was dissolved in 2000 mL of inositol hexaphosphate and uniformly dispersed, and then 50 g of ammonium persulfate was added. After uniform stirring, a reaction solution was obtained. The reaction solution was placed in a reaction kettle and reacted at 180 °C for 8 h to obtain a powder, and then the powder was placed in a muffle furnace and carbonized at a temperature of 900 °C for 4 h under nitrogen protection. Water vapor was introduced into the carbonized product at 450 °C for activation and pore formation treatment for 6 h, where the flow rate of the water vapor was 1 g/min, and then porous carbon skeleton primary particles were obtained.

With silane used as a silicon source and nitrogen used as a protective gas, vapor deposition was performed in a tube furnace to obtain a silicon-carbon composite material, where the flow rate of the silane was 0.06 L/min, and the flow rate of the protective gas was 4 L/min. The vapor deposition was performed at a temperature of 450 °C for 6 h to obtain silicon-carbon primary particles. The silicon-carbon primary particles were subjected to spray drying with an air outlet temperature of 95 °C and a feed rate of 0.6 L/h to obtain silicon-carbon secondary particles.

With methane used as a carbon source and nitrogen used as a protective gas, vapor deposition of the carbon source was performed on the silicon-carbon secondary particles in a tube furnace, where the flow rate of the methane was 6 L/min, and the flow rate of the protective gas was 15 L/min. The vapor deposition was performed at 900 °C for 6 h. A gas source was shut off for cooling to obtain an intermediate product. The obtained intermediate product and 19.9 g of single-walled carbon nanotube dispersion liquid were mixed and stirred to obtain a silicon-carbon composite material, where the length of the single-walled carbon nanotubes is 3 µm and the diameter thereof is 1 nm.

### II. Performance Test

### 1. Battery Performance

### 1) 40% SOC discharge time

The battery cell was discharged at a constant current of 0.33C to 2.8 V and left to stand for 30 min. The battery cell was then charged at a constant current of 0.33C to 4.25 V, followed by constant voltage charging at 0.05C until the voltage stabilizes, and left to stand for 30 min. The battery cell was then discharged at a constant current of 0.33C to 2.8 V, at which point the initial capacity C0 was read, and left to stand for 30 min. The battery cell was then charged at a constant current of 0.33C to 4.25 V, followed by constant voltage charging at 0.05C until the voltage stabilizes, and left to stand for 30 min. The battery cell was then discharged at a constant current of 0.33C to 0.4 C0 Ah (40% SOC) and left to stand for 60 min. Finally, the battery cell was discharged at a constant current of 4.5C to 2.8 V, with the discharge time recorded.

### 2) Fast charge time

At 25 °C, the batteries of the examples and comparative examples were subjected to a first charge and discharge cycle at a current of 1C (i.e., a current at which the rated capacity can be fully discharged within 1 h). Specifically, the batteries were charged at a constant current of 1C to a voltage of 4.3 V, followed by constant voltage charging to a current of ≤ 0.05C. The batteries were left to stand for 5 min, and then discharged at a constant current of 0.33C to a voltage of 2.8 V. The actual capacity was recorded as C0.

Subsequently, the batteries were charged sequentially at constant currents of 2.0 C0, 2.5 C0, 3.0 C0, 3.5 C0, 4.0 C0, 4.5 C0, 5.0 C0, and 5.5 C0 until reaching either the full-battery charge cut-off voltage of 4.3 V or the negative electrode cut-off potential of 0 V, whichever occurred first. After each charge cycle, the batteries were discharged at 1 C0 to the full-battery discharge cut-off voltage of 2.8 V, and the negative electrode potentials corresponding to 10%, 20%, 30%,..., 80% state of charge (SOC) at different charging rates were recorded. A charging rate-negative electrode potential curve was plotted for different SOC states, and linear fitting was performed to obtain the charging rates corresponding to a negative electrode potential of 0 V in different SOC states. The charging rates were defined as charging windows at the given SOC states and were recorded as C20%SOC, C30%SOC, C40%SOC, C50%SOC, C60%SOC, C70%SOC, and C80%SOC. The charge time T (unit: min) required for the battery to charge from 10% SOC to 80% SOC was calculated according to the formula: (60/C20%SOC + 60/C30%SOC + 60/C40%SOC + 60/C50%SOC + 60/C60%SOC + 60/C70%SOC + 60/C80%SOC) × 10%. Shorter time demonstrates more excellent fast-charging performance of the battery.

### 3) Cycle Performance

The secondary batteries prepared in the examples and comparative examples were charged at a constant current of 0.5C to a charge cut-off voltage of 4.25 V, followed by constant voltage charging until the current dropped to ≤ 0.05C. The batteries were then left to stand for 5 min, discharged at a constant current of 0.33C to a discharge cut-off voltage of 2 V, and left to stand for another 5 min. This process constituted one charge-discharge cycle. The battery was subjected to a charge-discharge cycle test using this method until the capacity of the battery declined to 80%. The number of cycles at this time was the cycle life of the battery at 25 °C.

### III. Analysis of Test Results of Examples and Comparative Examples

The batteries of examples and comparative examples were prepared according to the methods described above, and various performance parameters were measured. The results are shown in the table below.

**Table 1**

| | Silicon-carbon primary particles | | | | | | Silicon-carbon secondary particles | Secondary battery | | |
|---|---|---|---|---|---|---|---|---|---|---|
| No. | One-dimensional conductive agent | | | | | Dv50 /nm | Dv50 /µm | Fast charge time /min | 40% SOC discharge time/S | Number of cycles |
| | Type | Diameter /nm | Length /µm | Aspect ratio | Mass content | | | | | |
| Example 1 | Single-walled carbon nanotube | 5 | 3 | 600 | 0.30% | 60 | 2 | 19 | 162 | 803 |
| Example 2 | Multi-walled carbon nanotube | 80 | 2 | 25 | 0.30% | 60 | 2 | 23 | 154 | 408 |
| Example 3 | Vapor-grown carbon fiber | 2 | 4 | 2000 | 0.30% | 60 | 2 | 20 | 160 | 788 |
| Example 4 | Single-walled carbon nanotube | 0.5 | 3 | 6000 | 0.30% | 60 | 2 | 17 | 176 | 982 |
| Example 5 | Single-walled carbon nanotube | 1 | 3 | 3000 | 0.30% | 60 | 2 | 15 | 184 | 1081 |
| Example 6 | Single-walled carbon nanotube | 10 | 3 | 300 | 0.30% | 60 | 2 | 20 | 168 | 724 |
| Example 7 | Single-walled carbon nanotube | 12 | 3 | 250 | 0.30% | 60 | 2 | 21 | 162 | 702 |
| Example 8 | Single-walled carbon nanotube | 1 | 0.5 | 500 | 0.30% | 60 | 2 | 18 | 180 | 898 |
| Example 9 | Single-walled carbon nanotube | 1 | 1 | 1000 | 0.30% | 60 | 2 | 17 | 182 | 998 |
| Example 10 | Single-walled carbon nanotube | 1 | 5 | 5000 | 0.30% | 60 | 2 | 16 | 181 | 1021 |
| Example 11 | Single-walled carbon nanotube | 1 | 7 | 7000 | 0.30% | 60 | 2 | 17 | 178 | 1011 |
| Example 12 | Single-walled carbon nanotube | 1 | 3 | 3000 | 0.05% | 60 | 2 | 23 | 149 | 557 |
| Example 13 | Single-walled carbon nanotube | 1 | 3 | 3000 | 0.60% | 60 | 2 | 14 | 183 | 1062 |
| Example 14 | Single-walled carbon nanotube | 1 | 3 | 3000 | 0.70% | 60 | 2 | 25 | 148 | 608 |
| Example 15 | Single-walled carbon nanotube | 1 | 3 | 3000 | 0.30% | 15 | 2 | 26 | 136 | 478 |
| Example 16 | Single-walled carbon nanotube | 1 | 3 | 3000 | 0.30% | 20 | 2 | 14 | 179 | 892 |
| Example 17 | Single-walled carbon nanotube | 1 | 3 | 3000 | 0.30% | 100 | 2 | 26 | 158 | 921 |
| Example 18 | Single-walled carbon nanotube | 1 | 3 | 3000 | 0.30% | 120 | 2 | 28 | 156 | 926 |
| Comparative Example 1 | Conductive carbon black | / | / | / | 0.30% | 60 | 2 | 36 | 61 | 224 |
| Comparative Example 2 | / | / | / | / | / | 60 | 2 | 42 | 48 | 211 |
| Comparative Example 3 | Conductive carbon | / | / | / | / | / | 2 | 28 | 108 | 388 |
| Comparative Example 4 | Single-walled carbon nanotube | 1 | 3 | 3000 | 0.03% | 60 | 2 | 25 | 121 | 428 |

As can be seen from the results described above, the silicon-carbon composite materials in Examples 1-18 include the silicon-carbon secondary particles, and the silicon-carbon secondary particles include the silicon-carbon primary particles and the one-dimensional conductive agent distributed between the silicon-carbon primary particles, where the one-dimensional conductive agent is the single-walled carbon nanotubes, the multi-walled carbon nanotubes, or the carbon fibers. As can be seen from the comparison between Examples 1-18 and Comparative Example 1, compared with the silicon-carbon composite material in which the conductive carbon black zero-dimensional conductive agent is distributed between the primary particles, the one-dimensional conductive agent is distributed between the silicon-carbon primary particles of the silicon-carbon composite material of the present application, which is beneficial to shortening the fast charge time of the battery, and prolonging the discharge time of the battery, thereby improving the rate performance of the battery, increasing the number of cycles of the battery, and prolonging the cycle life of the battery. As can be seen from the comparison between Examples 1-18 and Comparative Example 2, compared with the silicon-carbon composite material in which no one-dimensional conductive agent is present between the primary particles, the one-dimensional conductive agent is distributed between the silicon-carbon primary particles of the silicon-carbon composite material of the present application, which is beneficial to shortening the fast charge time of the battery, and prolonging the discharge time of the battery, thereby improving the rate performance of the battery, increasing the number of cycles of the battery, and prolonging the cycle life of the battery. As can be seen from the comparison between Examples 1-18 and Comparative Example 3, compared with the conductive carbon zero-dimensional conductive agent being present in the porous carbon skeleton, the one-dimensional conductive agent of the present application is present between the primary particles, which is beneficial to shortening the fast charge time of the battery, and prolonging the discharge time of the battery, thereby improving the rate performance of the battery, increasing the number of cycles of the battery, and prolonging the cycle life of the battery. As can be seen from the comparison between Example 5 and Comparative Example 4, compared with the silicon-carbon composite material in which the one-dimensional conductive agent is present between the secondary particles, the one-dimensional conductive agent of the present application is distributed between the primary particles, which is beneficial to prolonging the discharge time of the battery, thereby improving the rate performance of the battery, increasing the number of cycles of the battery, and prolonging the cycle life of the battery.

As can be seen from the comparison between Examples 1 and 4-6 and Example 7, the diameter of the single-walled carbon nanotubes is controlled to be less than or equal to 10 nm, which is beneficial to increasing the number of cycles of the battery, prolonging the 40% SOC discharge time of the battery, and shortening the fast charge time of the battery, thereby improving the rate performance and cycle performance of the battery. As can be seen from the comparison between Examples 1 and 4-5 and Examples 6-7, the diameter of the single-walled carbon nanotubes is controlled to be 0.5 nm to 5 nm, which can further shorten the fast charge time of the battery, increase the number of cycles of the battery, and prolong the 40% SOC discharge time of the battery, thereby improving the rate performance and cycle performance of the battery.

As can be seen from the comparison between Examples 5 and 9-10 and Examples 8 and 11, the length of the single-walled carbon nanotubes is controlled to be 1 µm to 5 µm, which is beneficial to prolonging the 40% SOC discharge time of the battery, and shortening the fast charge time of the battery, thereby improving the rate performance of the battery. As can be seen from the comparison between Examples 5 and 10 and Examples 8-9 and 11, the length of the single-walled carbon nanotubes is controlled to be 3 µm to 5 µm, which can further increase the number of cycles of the battery, and shorten the fast charge time of the battery, thereby improving the cycle performance and the rate performance of the battery.

As can be seen from the comparison between Examples 5 and 9-10 and Examples 1, 4, 6-8, and 11, the aspect ratio of the single-walled carbon nanotubes is controlled to be 1000 to 5000, which is beneficial to prolonging the 40% SOC discharge time of the battery, and shortening the fast charge time of the battery, thereby improving the rate performance of the battery. As can be seen from the comparison between Examples 5 and 10 and Examples 1, 4, 6-9, and 11, the aspect ratio of the single-walled carbon nanotubes is controlled to be 3000 to 5000, which can further increase the number of cycles of the battery, and shorten the fast charge time of the battery, thereby improving the cycle performance and rate performance of the battery.

As can be seen from Examples 5 and 12-14, the mass content of the single-walled carbon nanotubes is less than or equal to 0.7%, based on the mass of the silicon-carbon secondary particles, and the battery has short fast charge time, long discharge time, and a large number of cycles, and thus has excellent rate performance and cycle performance. As can be seen from the comparison between Examples 5 and 13 and Examples 12 and 14, the mass content of the single-walled carbon nanotubes is 0.3% to 0.6%, based on the mass of the silicon-carbon secondary particles, which can increase the number of cycles of the battery, prolong the 40% SOC discharge time of the battery, and shorten the fast charge time of the battery, thereby improving the rate performance and the cycle performance of the battery.

As can be seen from the comparison between Examples 5 and 16-17 and Examples 15 and 18, the volume distribution particle size Dv50 of the silicon-carbon primary particles is controlled to be 20 nm to 100 nm, which can prolong the discharge time of the battery and shorten the charge time of the battery, thereby further improving the rate performance of the battery. As can be seen from the comparison between Examples 5 and 16 and Examples 15 and 17-18, the volume distribution particle size Dv50 of the silicon-carbon primary particles is controlled to be 20 nm to 60 nm, which can further prolong the discharge time of the battery, and shorten the charge time of the battery, thereby further improving the rate performance of the battery.

It should be noted that the present application is not limited to the embodiments described above. The embodiments described above are merely examples, and any embodiments having a structure substantially identical to the technical concept and exerting the same functional effects within the scope of the technical solutions of the present application are all included within the technical scope of the present application. Furthermore, without departing from the spirit of the present application, various modifications that can be conceived by those skilled in the art to the embodiments, as well as other embodiments formed by combining some of the constituent elements of the embodiments, are also included within the scope of the present application.

## Claims

1. A silicon-carbon composite material, comprising silicon-carbon secondary particles, wherein the silicon-carbon secondary particles comprise silicon-carbon primary particles and a one-dimensional conductive agent, and the one-dimensional conductive agent is distributed between the silicon-carbon primary particles.

2. The silicon-carbon composite material according to claim 1, wherein
a diameter of the one-dimensional conductive agent is less than or equal to 10 nm, optionally 0.5 nm to 5 nm; and/or
a length of the one-dimensional conductive agent is 1 µm to 5 µm, optionally 3 µm to 5 µm; and/or,
an aspect ratio of the one-dimensional conductive agent is 1000 to 5000, optionally 3000 to 5000.

3. The silicon-carbon composite material according to claim 1 or 2, wherein a mass content of the one-dimensional conductive agent is less than or equal to 0.7%, optionally 0.3% to 0.6%, based on a mass of the silicon-carbon secondary particles.

4. The silicon-carbon composite material according to any one of claims 1 to 3, wherein a particle size of the silicon-carbon primary particles is 20 nm to 100 nm, optionally 20 nm to 60 nm.

5. The silicon-carbon composite material according to any one of claims 1 to 4, wherein the silicon-carbon primary particles comprise:
a porous carbon skeleton; and
a silicon-based material, wherein at least a portion of the silicon-based material is arranged in pores of the porous carbon skeleton.

6. The silicon-carbon composite material according to claim 5, wherein the porous carbon skeleton satisfies at least one of the following (1) to (2):
(1) a pore volume of the porous carbon skeleton is 0.7 cm³/g to 1.0 cm³/g; and
(2) a pore size of the porous carbon skeleton is 0.7 nm to 3 nm, optionally 0.8 nm to 1.5 nm.

7. The silicon-carbon composite material according to claim 5 or 6, wherein the silicon-carbon primary particles satisfy at least one of the following (3) to (4):
(3) a specific surface area of the silicon-carbon primary particles is 1 m²/g to 20 m²/g, optionally 8 m²/g to 15 m²/g; and
(4) a mass fraction of the silicon-based material is 30% to 50%, optionally 35% to 45%, based on a mass of the silicon-carbon primary particles.

8. The silicon-carbon composite material according to any one of claims 1 to 7, wherein the silicon-carbon secondary particles satisfy at least one of the following (5) to (8):
(5) a specific surface area of the silicon-carbon secondary particles is 0.1 m²/g to 0.8 m²/g, optionally 0.15 m²/g to 0.6 m²/g;
(6) a volume distribution particle size Dv50 of the silicon-carbon secondary particles is 0.9 µm to 3 µm;
(7) a tap density of the silicon-carbon secondary particles is 0.75 g/cm³ to 1.00 g/cm³; and
(8) a powder resistivity of the silicon-carbon secondary particles at 5 MPa is 0.1 Ω·cm to 10 Ω·cm, optionally 0.1 Ω·cm to 1 Ω·cm.

9. The silicon-carbon composite material according to any one of claims 1 to 8, wherein the one-dimensional conductive agent comprises carbon nanotubes and carbon fibers, optionally carbon nanotubes, and more optionally single-walled carbon nanotubes.

10. The silicon-carbon composite material according to any one of claims 1 to 9, wherein a carbon layer is provided on at least a part of a surface of the silicon-carbon composite material.

11. A preparation method for a silicon-carbon composite material, comprising:
mixing and granulating silicon-carbon primary particles and a one-dimensional conductive agent in a solvent, and performing spray drying to obtain the silicon-carbon composite material,
wherein the silicon-carbon composite material comprises silicon-carbon secondary particles, the silicon-carbon secondary particles comprise silicon-carbon primary particles and a one-dimensional conductive agent, and the one-dimensional conductive agent is distributed between the silicon-carbon primary particles.

12. The preparation method according to claim 11, wherein the preparation method specifically comprises:
polymerization reaction: performing a polymerization reaction on aniline, inositol hexaphosphate, and an initiator to obtain a mixed precursor;
high-temperature carbonization: performing high-temperature carbonization treatment on the mixed precursor to obtain a carbonized pretreated material;
activation and pore formation: introducing water vapor into the carbonized pretreated material for activation and pore formation treatment to obtain porous carbon skeleton primary particles;
silicon deposition: depositing silicon in the porous carbon skeleton primary particles to obtain silicon-carbon primary particles; and
mixing and granulation: mixing and granulating the silicon-carbon primary particles and the one-dimensional conductive agent in a solvent, and performing spray drying to obtain the silicon-carbon composite material.

13. The preparation method according to claim 12, wherein a reaction temperature of the polymerization reaction is 60 °C to 280 °C, optionally 80 °C to 250 °C; and/or
a reaction time of the polymerization reaction is 1 h to 15 h, optionally 5 h to 12 h.

14. The preparation method according to claim 12 or 13, wherein a deposition temperature for silicon deposition is 400 °C to 900 °C, optionally 500 °C to 650 °C; and/or
a deposition time for silicon deposition is 6 h to 24 h, optionally 8 h to 18 h.

15. The preparation method according to any one of claims 11 to 14, wherein the preparation method further comprises preparing a carbon layer: performing carbon coating treatment on a surface of the silicon-carbon composite material.

16. A secondary battery, comprising a negative electrode plate, wherein the negative electrode plate comprises the silicon-carbon composite material according to any one of claims 1 to 10 or the silicon-carbon composite material prepared by the preparation method according to any one of claims 11 to 15.

17. An electric device, comprising the secondary battery according to claim 16.
